# EUROPEAN PATENT SPECIFICATION

(11) **EP 2 471 346 B1**
(45) Date of publication and mention of the grant of the patent: **28.11.2018**
(21) Application number: 10819235.2
(22) Date of filing: 09.09.2010
(51) Int. Cl.: H05B 37/02, H05B 33/08

(54) **SOLID STATE LIGHTING APPARATUS WITH CONFIGURABLE SHUNTS**
FESTKÖRPERBELEUCHTUNGSVORRICHTUNG MIT KONFIGURIERBAREN SHUNTS
APPAREIL D'ÉCLAIRAGE À SEMI-CONDUCTEURS AVEC SHUNTS CONFIGURABLES

(30) Priority: 24.09.2009 US 566142
(43) Date of publication of application: 04.07.2012
(73) Proprietor: Cree, Inc., Durham, NC 27703 (US)
(72) Inventor: VAN DE VEN, Antony P., Sai Kung Hong Kong (CN); NEGLEY, Gerald H., Chapel Hill, North Carolina 27517 (US)
(74) Representative: Boult Wade Tennant LLP
(86) International application number: PCT/US2010/048225
(87) International publication number: WO 2011/037752

(56) References cited:
- WO-A1-2007/090283
- WO-A1-2008/007121
- US-A1- 2007 278 974
- US-A1- 2008 150 439
- US-A1- 2008 309 255
- US-A1- 2009 160 363
- US-B1- 6 201 353
- US-B1- 6 329 764
- US-B1- 7 213 940
- US-B2- 6 630 801
- US-B2- 7 535 180

## Description

### FIELD OF THE INVENTION

The present invention relates to solid state lighting, and more particularly to lighting fixtures including solid state lighting components.

### BACKGROUND

Solid state lighting arrays are used for a number of lighting applications. For example, solid state lighting panels including arrays of solid state light emitting devices have been used as direct illumination sources, for example, in architectural and/or accent lighting. A solid state light emitting device may include, for example, a packaged light emitting device including one or more light emitting diodes (LEDs). Inorganic LEDs typically include semiconductor layers forming p-n junctions. Organic LEDs (OLEDs), which include organic light emission layers, are another type of solid state light emitting device. Typically, a solid state light emitting device generates light through the recombination of electronic carriers, i.e. electrons and holes, in a light emitting layer or region.

Solid state lighting panels are commonly used as backlights for small liquid crystal display (LCD) screens, such as LCD display screens used in portable electronic devices. In addition, there has been increased interest in the use of solid state lighting panels as backlights for larger displays, such as LCD television displays.

For smaller LCD screens, backlight assemblies typically employ white LED lighting devices that include a blue-emitting LED coated with a wavelength conversion phosphor that converts some of the blue light emitted by the LED into yellow light. The resulting light, which is a combination of blue light and yellow light, may appear white to an observer. However, while light generated by such an arrangement may appear white, objects illuminated by such light may not appear to have a natural coloring, because of the limited spectrum of the light. For example, because the light may have little energy in the red portion of the visible spectrum, red colors in an object may not be illuminated well by such light. As a result, the object may appear to have an unnatural coloring when viewed under such a light source.

The color rendering index (CRI) of a light source is an objective measure of the ability of the light generated by the source to accurately illuminate a broad range of colors. The color rendering index ranges from essentially zero for monochromatic sources to nearly 100 for incandescent sources. Light generated from a phosphor-based solid state light source may have a relatively low color rendering index.

For large-scale backlight and illumination applications, it is often desirable to provide a lighting source that generates a white light having a high color rendering index, so that objects and/or display screens illuminated by the lighting panel may appear more natural. Accordingly, to improve CRI, red light may be added to the white light, for example, by adding red emitting phosphor and/or red emitting devices to the apparatus. Other lighting sources may include red, green and blue light emitting devices. When red, green and blue light emitting devices are energized simultaneously, the resulting combined light may appear white, or nearly white, depending on the relative intensities of the red, green and blue sources. US-2008/150439 concerns a circuit for driving multiple light emitting diodes coupled in series, including multiple switches for receiving multiple burst mode modulations signals respectively. Each switch is coupled in parallel with the corresponding light emitting diode and for individually controlling brightness of the corresponding light emitting diode.

### SUMMARY

A solid state lighting apparatus is provided in line with claim 1. This includes a circuit including a plurality of light emitting devices, and a configurable shunt configured to bypass at least some current around at least one light emitting device of the plurality of light emitting devices. The configurable shunt may include, for example, a tunable resistor, a fuse, a switch, a thermistor, and/or a variable resistor.

A solid state lighting apparatus embodiments includes a string of series-connected solid state light emitting devices. The string includes an anode terminal at a first end of the string and a cathode terminal at a second end of the string. At least one configurable shunt is provided between a contact of one of the solid state light emitting devices and the cathode or anode terminal of the string. The configurable shunt electrically bypasses at least one of the solid state light emitting devices when a voltage is applied across the anode and cathode terminals of the string.

Each of the solid state lighting devices includes an anode contact and a cathode contact. The anode contact of each of the solid state light emitting devices may be coupled to the cathode contact of an adjacent solid state light emitting device in the string or to the anode terminal of the string, and the cathode contact of each of the solid state light emitting devices may be coupled to the anode contact of an adjacent solid state light emitting device in the string or to the cathode terminal of the string.

The switch may include an electrically controllable switch, and the solid state lighting apparatus may further include a control circuit coupled to the switch and configured to electrically control an ON/OFF state of the switch.

The solid state lighting apparatus may further include an interface coupled to the control circuit and configured to receive an external input and responsively provide a switch command to the control circuit, and the control circuit may be configured to control the ON/OFF state of the switch in response to the switch command.

The solid state lighting apparatus may further include a plurality of configurable shunts coupled between anode contacts of respective ones of the solid state light emitting devices and the cathode terminal of the string. The solid state light emitting devices may include respective groups of series-connected solid state light emitting devices. The groups of series-connected solid state light emitting devices may be connected in series between the anode contact of the string and the cathode contact of the string, and the configurable shunts may be coupled between anode contacts of first solid state light emitting devices in each of the respective groups and the cathode terminal of the string.

At least two groups of solid state light emitting devices can include different numbers of solid state light emitting devices.

A first group of solid state light emitting devices may be coupled directly to the cathode terminal of the string and may include a first number of solid state light emitting devices, and a second group of solid state light emitting devices may be not coupled directly to the cathode terminal of the string and may include a second number of solid state light emitting devices. The first number may be not equal to the second number. In some embodiments the first number may be less than the second number, while in other embodiments, the first number may be greater than the second number.

The solid state light emitting apparatus may further include a thermistor coupled in series with the LEDs in the string and/or a thermistor coupled in parallel with the LEDs in the string.

The solid state light emitting apparatus may further include a variable resistor coupled in series and/or a variable resistor coupled in parallel with the LEDs in the string.

The string may include a first string of light emitting diodes configured to emit light having a first chromaticity, and the apparatus may further include a second string of light emitting devices configured to emit light having a second chromaticity, different from the first chromaticity. The first chromaticity and the second chromaticity may be non-white, and light emitted by both the first and second strings may have a combined chromaticity that is white.

The second string of light emitting devices may include a second configurable shunt configured to bypass at least some current in the second string around at least one light emitting device in the second string.

In some embodiments, at least two of the light emitting devices may be connected in parallel, and the configurable shunt may be configured to bypass current around the at least two parallel connected light emitting devices.

A method of operating a solid state lighting apparatus is provided in accordance with claim 12. The apparatus in diode including a string of series-connected solid state light emitting devices, each of the solid state light emitting devices including an anode contact and a cathode contact, and the string including an anode terminal at a first end of the string and a cathode terminal at a second end of the string. The method includes passing a reference current through the string, measuring color and/or intensity of light output from the string in response to the reference current, and providing at least one configurable shunt coupled between a contact of one of the solid state light emitting devices and the cathode or anode terminal of the string in response to the measured color and/or intensity of light output from the string. The configurable shunt electrically bypasses at least one of the solid state light emitting devices when a voltage is applied across the anode and cathode terminals of the string.

The string may include a first string of solid state light emitting devices configured to emit light having a dominant wavelength in a first portion of the visible spectrum, and the solid state lighting apparatus may further include a second string of solid state light emitting devices configured to emit light having a dominant wavelength in a second portion of the visible spectrum, different from the first portion. The methods may further include passing a second reference current through the second string, and measuring color and/or intensity of light output may include measuring color and/or intensity of light output from the first string and the second string in response to the reference current and the second reference current.

Providing the configurable shunt may include activating a switch coupled between the contact of the one of the solid state light emitting devices and the cathode or anode terminal of the string.

Providing the configurable shunt may include varying a resistance of a tunable resistor coupled between the contact of the one of the solid state light emitting devices and the cathode or anode terminal of the string.

Other apparatus and/or methods according to embodiments of the invention will be or become apparent to one with skill in the art upon review of the following drawings and detailed description. It is intended that all such additional apparatus and/or methods be included within this description, be within the scope of the present invention, and be protected by the accompanying claims

### BRIEF DESCRIPTION OF THE DRAWINGS

The accompanying drawings, which are included to provide a further understanding of the invention and are incorporated in and constitute a part of this application, illustrate certain embodiment(s) of the invention. In the drawings:
FIGS. 1A and 1B illustrate a solid state lighting apparatus in accordance with some embodiments of the invention.
FIG. 2 is a schematic circuit diagram illustrating series interconnection of light emitting devices (LEDs) in a solid state lighting apparatus.
FIGS. 3-6 are schematic circuit diagrams illustrating the electrical interconnection of LEDs in a solid state lighting apparatus in accordance with various embodiments of the invention.
FIGS. 7A and 7B are schematic circuit diagrams illustrating the electrical interconnection of LEDs in a solid state lighting apparatus, Fig. 7A not being in accordance with the invention, but Fig.7B being in accordance with various embodiments of the invention.
FIG. 8, is a graph of light intensity versus junction temperature for LEDs having emission wavelengths of 460 nm and 527 nm.
FIG. 9 is a schematic circuit diagram illustrating the electrical interconnection of LEDs in a solid state lighting apparatus in accordance with further embodiments of the invention.
FIG. 10 illustrates systems/methods used to configure the color point of a solid state lighting apparatus according to some embodiments.
FIG. 11 is a flowchart illustrating operations of configuring the color point of a solid state lighting apparatus according to some embodiments of the invention.
FIGS. 12-15 are schematic circuit diagrams illustrating the electrical interconnection of LEDs in solid state lighting apparatus in accordance with further embodiments of the invention.

### DETAILED DESCRIPTION OF EMBODIMENTS

Embodiments of the present invention now will be described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer or region to another element, layer or region as illustrated in the figures. It will be understood that these terms are intended to encompass different orientations of the device in addition to the orientation depicted in the figures.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" "comprising," "includes" and/or "including" when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms used herein should be interpreted as having a meaning that is consistent with their meaning in the context of this specification and the relevant art and will not be interpreted in an idealized or overly formal sense unless expressly so defined herein.

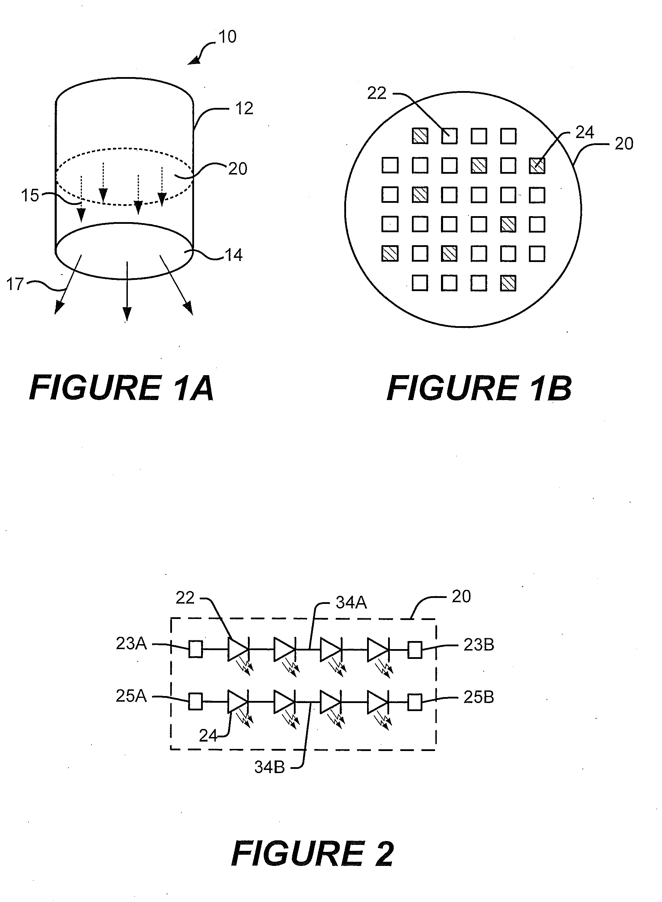

Referring to Figures 1A and 1B, a lighting apparatus 10 according to some embodiments is illustrated. The lighting apparatus 10 shown in Figures 1A and 1B is a "can" lighting fixture that may be suitable for use in general illumination applications as a down light or spot light. However, it will be appreciated that a lighting apparatus according to some embodiments may have a different form factor. For example, a lighting apparatus according to some embodiments can have the shape of a conventional light bulb, a pan or tray light, an automotive headlamp, or any other suitable form.

The lighting apparatus 10 generally includes a can shaped outer housing 12 in which a lighting panel 20 is arranged. In the embodiments illustrated in Figures 1A and 1B, the lighting panel 20 has a generally circular shape so as to fit within an interior of the cylindrical housing 12. Light is generated by solid state lighting devices (LEDs) 22, 24, which are mounted on the lighting panel 20, and which are arranged to emit light 15 towards a diffusing lens 14 mounted at the end of the housing 12. Diffused light 17 is emitted through the lens 14. In some embodiments, the lens 14 may not diffuse the emitted light 15, but may redirect and/or focus the emitted light 15 in a desired near-field or far-field pattern.

Still referring to Figures 1A and 1B, the solid-state lighting apparatus 10 may include a plurality of first LEDs 22 and a plurality of second LEDs 24. In some embodiments, the plurality of first LEDs 22 may include white emitting, or near white emitting, light emitting devices. The plurality of second LEDs 24 may include light emitting devices that emit light having a different dominant wavelength from the first LEDs 22, so that combined light emitted by the first LEDs 22 and the second LEDs 24 may have a desired color and/or spectral content.

For example, the combined light emitted by the plurality of first LEDs 22 and the plurality of second LEDs 24 may be warm white light that has a high color rendering Index.

The chromaticity of a particular light source may be referred to as the "color point" of the source. For a white light source, the chromaticity may be referred to as the "white point" of the source. The white point of a white light source may fall along a locus of chromaticity points corresponding to the color of light emitted by a black-body radiator heated to a given temperature. Accordingly, a white point may be identified by a correlated color temperature (CCT) of the light source, which is the temperature at which the heated black-body radiator matches the hue of the light source. White light typically has a CCT of between about 2500K and 8000K. White light with a CCT of 2500K has a reddish color, white light with a CCT of 4000K has a yellowish color, and while light with a CCT of 8000K is bluish in color.

"Warm white" generally refers to white light that has a CCT between about 3000 and 3500 °K. In particular, warm white light may have wavelength components in the red region of the spectrum, and may appear yellowish to an observer. Warm white light typically provides a relatively high CRI, and accordingly can cause illuminated objects to have a more natural color. For illumination applications, it is therefore desirable to provide a warm white light.

In order to achieve warm white emission, conventional packaged LEDs include either a single component orange phosphor in combination with a blue LED or a mixture of yellow/green and orange/red phosphors in combination with a blue LED. However, using a single component orange phosphor can result in a low CRl as a result of the absence of greenish and reddish hues. On the other hand, red phosphors are typically much less efficient than yellow phosphors. Therefore, the addition of red phosphor in yellow phosphor can reduce the efficiency of the package, which can result in poor luminous efficacy. Luminous efficacy is a measure of the proportion of the energy supplied to a lamp that is converted into light energy. It is calculated by dividing the lamp's luminous flux, measured in lumens, by the power consumption, measured in watts.

Warm white light can also be generated by combining non-white light with red light as described in U.S. Patent No. 7,213,940, entitled "LIGHTING DEVICE AND LIGHTING METHOD," which is assigned to the assignee of the present invention, and the disclosure of which is incorporated herein by reference. As described therein, a lighting device may include first and second groups of solid state light emitters, which emit light having dominant wavelength in ranges of from 430 nm to 480 nm and from 600 nm to 630 nm, respectively, and a first group of phosphors which emit light having dominant wavelength in the range of from 555 nm to 585 nm. A combination of light exiting the lighting device which was emitted by the first group of emitters, and light exiting the lighting device which was emitted by the first group of phosphors produces a sub-mixture of light having x, y color coordinates within a defined area on a 1931 CIE Chromaticity Diagram that is referred to herein as "blue-shifted yellow" or "BSY." Such non-white light may, when combined with light having a dominant wavelength from 600 nm to 630 nm, produce warm white light.

Blue and/or green LEDs used in a lighting apparatus according to some embodiments may be InGaN-based blue and/or green LED chips available from Cree, Inc., the assignee of the present invention. Red LEDs used in the lighting apparatus may be, for example, AllnGaP LED chips available from Epistar, Osram and others.

In some embodiments, the LEDs 22, 24 may have a square or rectangular periphery with an edge length of about 900 µm or greater (i.e. so-called "power chips." However, in other embodiments, the LED chips 22, 24 may have an edge length of 500 µm or less (i.e. so-called "small chips"). In particular, small LED chips may operate with better electrical conversion efficiency than power chips. For example, green LED chips with a maximum edge dimension less than 500 microns and as small as 260 microns, commonly have a higher electrical conversion efficiency than 900 micron chips, and are known to typically produce 55 lumens of luminous flux per Watt of dissipated electrical power and as much as 90 lumens of luminous flux per Watt of dissipated electrical power.

The LEDs 22 in the lighting apparatus 10 may include white/BSY emitting LEDs, while the LEDs 24 in the lighting apparatus may emit red light. The LEDs 22, 24 in the lighting apparatus 10 may be electrically interconnected in respective strings, as illustrated in the schematic circuit diagram in Figure 2. As shown therein, the LEDs 22, 24 may be interconnected such that the white/BSY LEDs 22 are connected in series to form a first string 34A. Likewise, the red LEDs 24 may be arranged in series to form a second string 34B. Each string 32, 34 may be connected to a respective anode terminal 23A, 25A and a cathode terminal 23B, 25B.

Although two strings 34A, 34B are illustrated in Figure 2, it will be appreciated that the lighting apparatus 10 may include more or fewer strings. Furthermore, there may be multiple strings of white/BSY LEDs 22, and multiple strings of red or other colored LEDs 24.

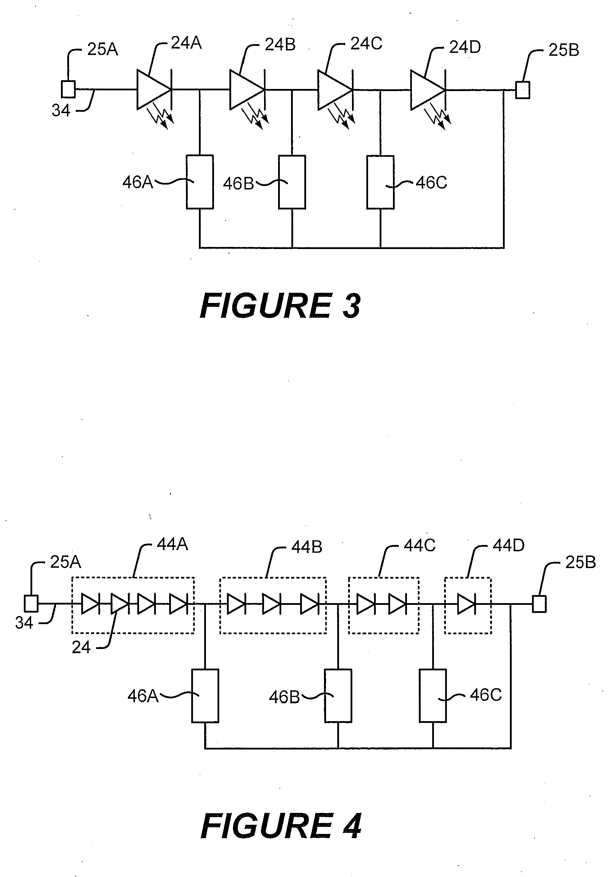

Referring now to Figure 3, an LED string 34 of a solid state lighting apparatus 10 according to some embodiments is illustrated in more detail. The LED string 34 could correspond to either or both of the strings 34A, 34B illustrated in Figure 2. The string 34 includes four LEDs 24A-24D connected in series between an anode terminal 25A and a cathode terminal 25B. In the embodiments illustrated in Figure 3, the string 34 includes four LEDs 24A-24D. However, the string 34 may include more or fewer LEDs.

Each of the solid state LEDs 24A-24C includes an anode contact and a cathode contact. The anode contact of each of the LEDs is coupled to the cathode contact of an adjacent LED in the string or to the anode terminal 25A of the string, and the cathode contact of each of the LEDs is coupled to the anode contact of an adjacent LED in the string or to the cathode terminal 25B of the string.

A plurality of configurable shunts 46A-46C are coupled between an anode contact of a respective one of the LEDs 24B-24D and the cathode terminal 25B of the string 34. Each of the configurable shunts 46A-46C may electrically bypass, for example by short circuiting, one or more of the solid state light emitting devices when a voltage is applied across the anode and cathode terminals 25A, 25B of the string 34.

The configurable shunts 46A-46C may be configured to be conductive or non-conductive. In some embodiments, the conduction state of the configurable shunts 46A-46C may be electrically and/or manually controllable/settable. For example, the configurable shunts 46A-46C may include tunable resistors that can be tuned between a high impedance state and a low impedance state. The tunable resistors may be manually and/or electrically tunable.

In other embodiments, the configurable shunts 46A-46C may be settable to a conductive state or a non-conductive state, and may remain in such a state after being set. For example, the configurable shunts 46A-46C may include fuses, switches, jumpers, etc., that can be set to a conductive or non-conductive state.

Thus, for example, by configuring one of the configurable shunts 46A-46C to be conductive, one or more of the LEDs 24B-24D may be switched out of the string 34, so that the string 34 effectively includes fewer LEDs 24A-24D. The total luminescent power output by the string 34 will thereby be reduced, which means that the color point of mixed light that is a combination of light emitted by the string 34 and another string 32 within the lighting apparatus 10 will be altered. The color point of the lighting apparatus 10 may thereby be adjusted by configuring the conduction state of the configurable shunts 46A-46C of the string 34..

Current through the string 34 may be provided by a constant current source, such as the variable voltage boost current source described in U.S. Publication No. 20070115248, assigned to the assignee of the present invention, and the disclosure of which is incorporated herein by reference. Thus, switching one or more of the LEDs 24A-24D out of the string 34 may not affect the current supplied to the string.

Referring to Figures 4-5, the solid state light emitting devices may be arranged into respective groups 44A-44C of series-connected solid state light emitting devices 24. The groups 44A-44C of series-connected solid state light emitting devices are connected in series between the anode contact 25A of the string 34 and the cathode contact 25B of the string 34. The configurable shunts 46A-46C are coupled to cathode contacts of the last solid state light emitting devices in each of the respective groups 44A-44C and to the cathode terminal 25B of the string 34.

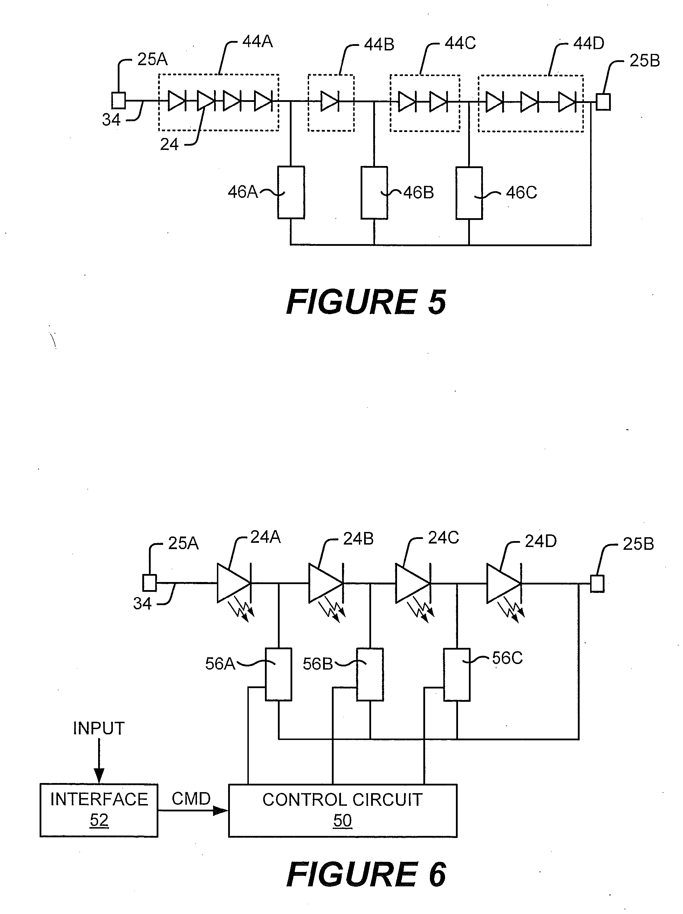

As illustrated in Figures 4-5, at least two groups 44A-44C include different numbers of solid state light emitting devices 24. For example, in the configuration illustrated in Figure 4, group 44A includes four LEDs 24, group 44B includes three LEDs, and group 44C includes two LEDs. In the configuration illustrated in Figure 5, group 44A includes four LEDs 24, group 44B includes one LED, and group 44C includes two LEDs. Accordingly, in the configuration illustrated in Figure 4, the string 34 may effectively include four, seven, nine or ten LEDs depending on the conduction/nonconduction states of the configurable shunts 46A-46C.

In contrast, in the configuration illustrated in Figure 5, the string 34 may effectively include four, five, seven or ten LEDs depending on the conduction/nonconduction states of the configurable shunts 46A-46C. Many other configurations are possible according to other embodiments. Accordingly, the number of LEDs in a group 44A-44C and the arrangement of the configurable shunts 46A-46C affects the ability of a system or user to configure the number of LEDs that will actually be energized when a voltage is applied to the anode and cathode terminals 25A, 25B of the string 34.

As noted above, a configurable shunt 46A-46C may include a switch coupled between the anode contact of the one of the solid state light emitting devices 24A-24D and the cathode terminal 25B of the string. Referring to Figure 6, the switch may include an electrically controllable switch 56A-56C, and the solid state lighting apparatus may further include a control circuit 50 coupled to the switches 56A-56C and configured to electrically control an ON/OFF state of the switches 56A-56C.

The solid state lighting apparatus 10 may further include an interface 52 coupled to the control circuit 50 and configured to receive an external input and responsively provide a switch command CMD to the control circuit 50. The control circuit 50 may be configured to control the ON/OFF state of the switches 56A-56C in response to the switch command. The external input may comprise an electronic and/or manual input.

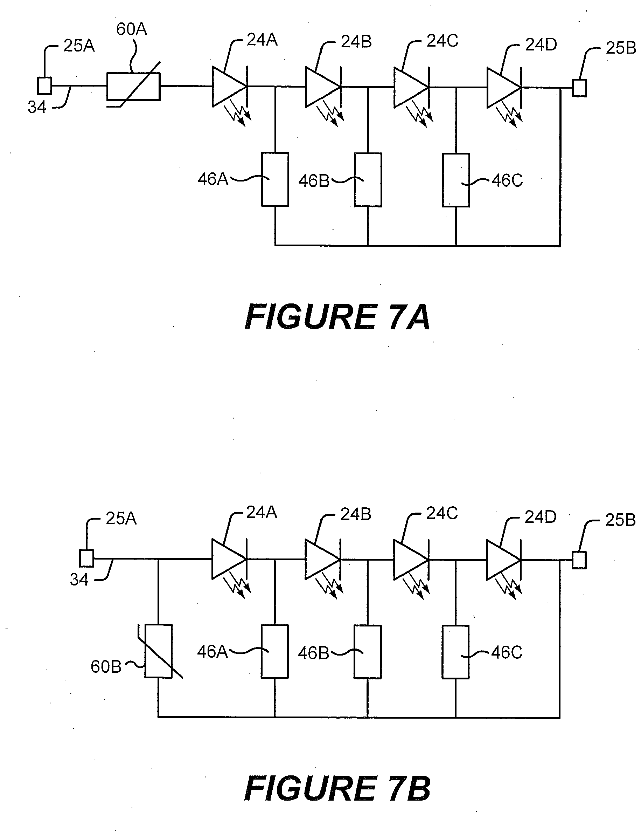

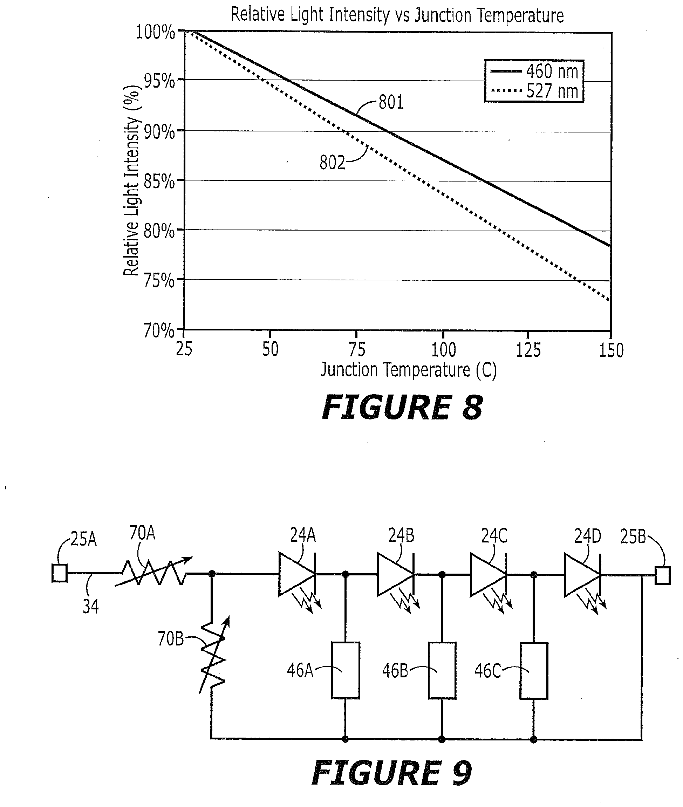

Referring to Figures 7A and 7B, the solid state light emitting apparatus 10 may further include a thermistor 60A coupled in series with the LEDs 24A-24D (Figure 7A) and/or a thermistor 60B coupled in parallel (Figure 7B) with the LEDs 24A-24D in the string 34. The thermistor 60 may be used to compensate for changes in light emission characteristics of the LEDs 24 that occur in response to changes in the junction temperature of the LEDs 24. In particular, it is known that the luminescent output of LEDs may decrease with increased junction temperature, as illustrated in Figure 8, which is a graph of light intensity versus junction temperature for EZ1000 LEDs manufactured by Cree, Inc., Durham, NC having emission wavelengths of 460 nm (curve 801) and 527 nm (curve 802).

Accordingly, the series connected thermistor 60A may have a negative temperature coefficient (i.e., the resistance of the thermistor 60A decreases with increased temperature) while the parallel connected thermistor 60B may have a positive temperature coefficient (resistance increases with increased temperature), so that current passing through LEDs 24 may be increased with increasing temperature to compensate for the reduction in light intensity as the temperature of the devices increases.

Referring to Figure 9, the solid state light emitting apparatus may further include a variable resistor 70A coupled in series with the string 34 and/or a variable resistor 70B coupled in parallel with the string 34. The resistances of the variable resistors 70A, 70B can be dynamically altered to compensate for temperature-induced changes in light emission as described above in connection with the thermistors 60A, 60B, and also to compensate for drift in the emission characteristics of the LEDs 24A-24D that can occur over time.

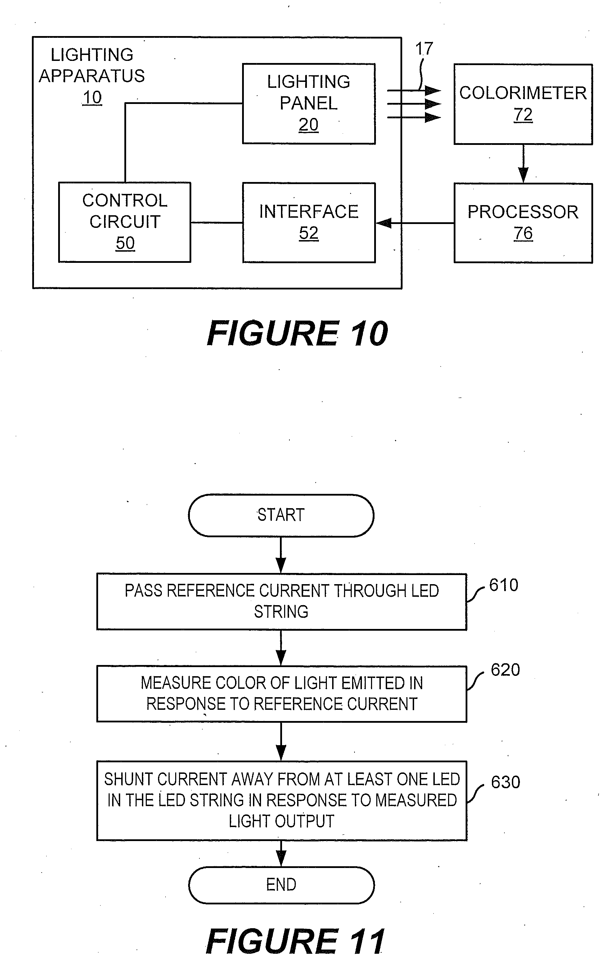

Figures 10 and 11 illustrate systems/methods used to calibrate a lighting apparatus 10 according to some embodiments. As shown therein, a lighting apparatus 10 including a lighting panel 20, a control circuit 50 and an interface 52 may be calibrated using a colorimeter 72 and a processor 76. Light 17 generated by the lighting panel 20 is emitted by the lighting apparatus 10 and detected by the colorimeter 72. The colorimeter 72 may be, for example, a PR-650 SpectraScan® Colorimeter from Photo Research Inc., which can be used to make direct measurements of luminance, CIE Chromaticity (1931 xy and 1976 u'v') and/or correlated color temperature. A color point of the light 17 may be detected by the colorimeter 72 and communicated to the processor 76. In response to the detected color point of the light 17, the processor 76 may determine that light output of one or more strings of LEDs in the lighting panel 20 should be altered by switching one or more LEDs, or groups of LEDs out of the string using the configurable shunts. The processor 76 may then issue a command to the control circuit 50 via the interface 52 to set the conductivity of one or more of the configurable shunts, and thereby adjust the color point of the light 17 output by lighting panel 20.

Figure 11 is a flowchart illustrating operations according to some embodiments for adjusting the light output of a string of series-connected LEDs 24A-24D, such as the string 34 illustrated in Figure 3. A reference current is passed through the string 34 (Block 610), and color and/or intensity of light output from the string in response to the reference current is measured (Block 620). In response to the measured color and/or intensity of the light output by the string 34, at least one configurable shunt 46A-46C is provided between an anode contact of one of the LEDs 24A-24D and the cathode terminal of the string 34 (Block 630). The configurable shunt 46A-46C electrically bypasses at least one of the LEDs 24A-24D when a voltage is applied across the anode and cathode terminals of the string 34.

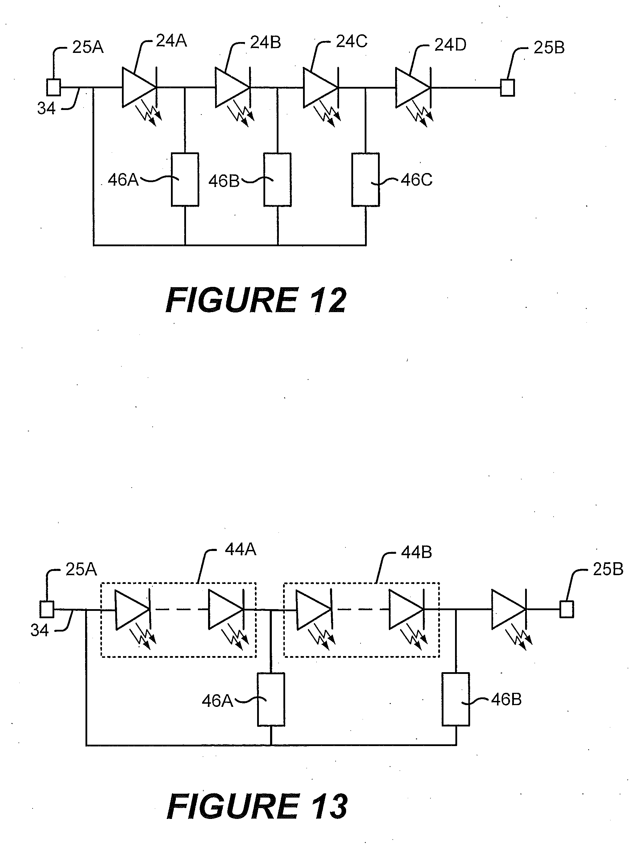

Further embodiments are illustrated in Figures 12-15. As shown in Figure 12, the configurable shunts 46A-46C may be provided between respective cathode contacts of the LEDs 24A-24C and the anode contact 25A of the string 34. Similarly, as shown in Figure 13, the configurable shunts 46A-46C may be provided between respective cathode contacts of groups 44A-44C of LEDs and the anode contact 25A of the string 34.

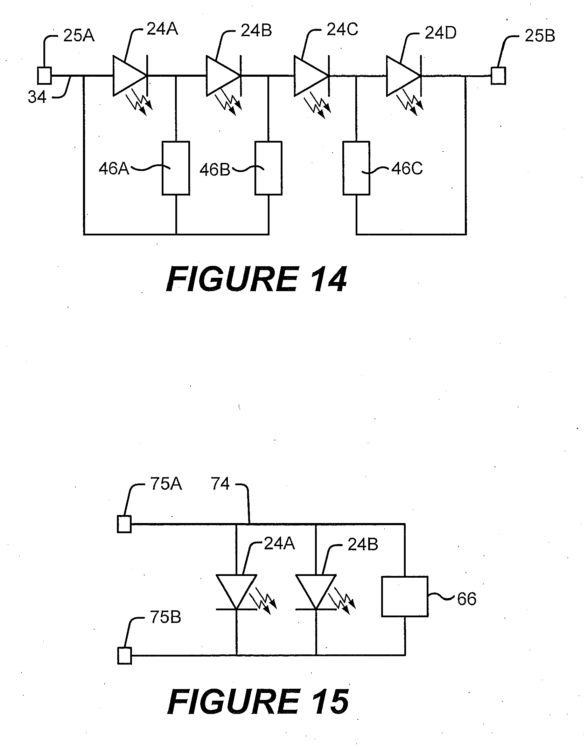

In further embodiments, some of the configurable shunts may be provided between anode contacts of some of the LEDs 24A-24D and the cathode contact 25B of the string 34, while others of the configurable shunts may be provided between cathode contacts of some of the LEDs 24A-24D and the anode contact 25A of the string 34. For example, in the embodiments illustrated in Figure 14, the configurable shunts 46A, 46B are connected between the cathodes of the LEDs 24A, 24B and the anode contact 25A of the string 34, while the configurable shunt 46C is connected between the anode of the LED 24D and the cathode contact 25B of the string 34.

Still further embodiments are illustrated in Figure 15. As shown therein, a circuit 74 includes light emitting devices 24A, 24B connected in parallel between anode and cathode contacts 75A, 75B. A configurable shunt 66 is connected in parallel with the light emitting devices 24A, 24B. The configurable shunt 66 may include a switch, fuse, thermistor, variable resistor, etc., as described above. The configurable shunt may be configured and/or controlled to alter current flowing through the parallel light emitting devices 24A, 24B.

Some embodiments of the present invention are described above with reference to flowchart illustrations and/or block diagrams of methods, systems and computer program products according to embodiments of the invention. It is to be understood that the functions/acts noted in the blocks may occur out of the order noted in the operational illustrations. For example, two blocks shown in succession may in fact be executed substantially concurrently or the blocks may sometimes be executed in the reverse order, depending upon the functionality/acts involved. Although some of the diagrams include arrows on communication paths to show a primary direction of communication, it is to be understood that communication may occur in the opposite direction to the depicted arrows.

In the drawings and specification, there have been disclosed typical embodiments of the invention and, although specific terms are employed, they are used in a generic and descriptive sense only and not for purposes of limitation, the scope of the invention being set forth in the following claims.

## Claims

1. A solid state lighting apparatus comprising:
a circuit comprising a plurality of light emitting devices, wherein the light emitting devices are connected in series to form a string (34) including an anode terminal (23A) at a first end of the string and a cathode terminal (23B) at a second end of the string;
a first configurable shunt (46C) that is connected between a terminal of a first light emitting device (24D) in the string and one of the cathode or anode terminal of the string and configured to bypass at least some current around the first light emitting device (24D);
a second configurable shunt (46B) coupled between a terminal of a second light emitting device (24C) and a same end terminal of the string (34) as the first configurable shunt (46C) and configured to bypass at least some current around the first light emitting device (24D) and the second light emitting device (24C); and
a thermistor and/or variable resistor (60B,70B) coupled between the same end terminal of the string as the first and second configurable shunts and the other one of the cathode or anode terminal of the string.

2. The solid state lighting apparatus of Claim 1, wherein the first (46C) and second (46B) configurable shunts each comprise at least one of a tunable resistor, a fuse, a switch, a thermistor and a variable resistor.

3. The solid state lighting apparatus of Claim 1, wherein each of the solid state light emitting devices includes an anode contact and a cathode contact, the anode contact of each of the solid state light emitting devices is coupled to the cathode contact of an adjacent solid state light emitting device in the string or to the anode terminal of the string, and the cathode contact of each of the solid state light emitting devices is coupled to the anode contact of an adjacent solid state light emitting device in the string or to the cathode terminal of the string.

4. The solid state lighting apparatus of Claim 3, wherein the first configurable shunt (56C) comprises an electrically controllable switch, the solid state lighting apparatus further comprising a control circuit (50) coupled to the electrically controllable switch and configured to electrically control an ON/OFF state of the electrically controllable switch;
wherein the solid state lighting apparatus further comprises an interface (52) coupled to the control circuit and configured to receive an external input and responsively provide a switch command to the control circuit, wherein the control circuit is configured to control the ON/OFF state of the electrically controllable switch in response to the switch command.

5. The solid state lighting apparatus of Claim 1, wherein the solid state light emitting devices comprise respective groups of series-connected solid state light emitting devices, wherein the groups of series-connected solid state light emitting devices are connected in series between the anode contact of the string (34) and the cathode contact of the string (34), and wherein the first and second configurable shunts are coupled between respective groups of series-connected solid state light emitting devices and the cathode (23B) or anode (23A) terminal of the string.

6. The solid state lighting apparatus of Claim 5, wherein at least two groups of solid state light emitting devices comprise different numbers of solid state light emitting devices, wherein a first group of solid state light emitting devices is coupled directly to the cathode terminal (23B) of the string and includes a first number of solid state light emitting devices, and wherein a second group of solid state light emitting devices is not coupled directly to the cathode terminal of the string and includes a second number of solid state light emitting devices, wherein the first number is not equal to the second number.

7. The solid state lighting apparatus of Claim 1, further comprising at least one of a thermistor and a variable resistor (70A) coupled in series with the string.

8. The solid state lighting apparatus of Claim 1, wherein the string comprises a first string (34A) of light emitting diodes configured to emit light having a first chromaticity, the apparatus further comprising a second string (34B) of light emitting devices configured to emit light having a second chromaticity, different from the first chromaticity.

9. The solid state lighting apparatus of Claim 8, wherein the first chromaticity and the second chromaticity are non-white, and wherein light emitted by both the first (34A) and second (34B) strings has a combined chromaticity that is white.

10. The solid state lighting apparatus of Claim 8, wherein the second string (34B) of light emitting devices comprises a second configurable shunt configured to bypass at least some current in the second string around at least one light emitting device in the second string.

11. The solid state lighting apparatus of Claim 1, wherein at least two of the light emitting devices (24A, 24B) are connected in parallel, and the configurable shunt (66) is configured to bypass current around the at least two parallel connected light emitting devices.

12. A method of operating a solid state lighting apparatus including a circuit comprising a plurality of solid state light emitting devices connected in series to form a first string of series-connected solid state light emitting devices configured to emit light having a dominant wavelength in a first portion of the visible spectrum and a second string (34B) of solid state light emitting devices configured to emit light having a dominant wavelength in a second portion of the visible spectrum different from the first portion, the first string including an anode terminal (23A) at a first end of the first string and a cathode terminal (23B) at a second end of the first string, the method comprising:
passing a first reference current through the first string (34A);
passing a second reference current through the second string (34B);
measuring color and/or intensity of light output from the first string and the second string in response to the first reference current and the second reference current;
providing at least two configurable shunts (46B, 46C), wherein each of the at least two shunts is directly coupled between a terminal of one of the solid state light emitting devices and the anode (23A) or cathode (23B) terminal of the first string such that the at least two shunts are coupled to a same end terminal of the first string; providing a thermistor and/or variable resistor (60B,70B) coupled between the same end terminal of the string as the at least two shunts and the other one of the cathode or anode terminal of the first string; and
increasing the first reference current to compensate for a reduction in light intensity as the temperature of the first string (34A) increases.

## Patentansprüche

1. Feststoff-Leuchtvorrichtung, umfassend:
eine Schaltung, umfassend eine Mehrzahl von Licht emittierenden Vorrichtungen, wobei die Licht emittierenden Vorrichtungen in Reihe verbunden sind, um einen Strang (34) zu bilden, umfassend einen Anodenanschluss (23A) an einem ersten Ende des Strangs und einen Kathodenanschluss (23B) an einem zweiten Ende des Strangs;
eine erste konfigurierbare Abzweigung (46C), welche zwischen einem Anschluss einer ersten Licht emittierenden Vorrichtung (24D) in dem Strang und einem aus dem Kathoden- oder Anodenanschluss des Strangs verbunden ist und dazu eingerichtet ist, wenigstens etwas Strom um die erste Licht emittierende Vorrichtung (24D) herum zu leiten;
eine zweite konfigurierbare Abzweigung (46B), welche zwischen einem Anschluss einer zweiten Licht emittierenden Vorrichtung (24C) und einem gleichen Endanschluss des Strangs (34) wie die erste konfigurierbare Abzweigung (46C) gekoppelt ist und dazu eingerichtet ist, wenigstens etwas Strom um die erste Licht emittierende Vorrichtung (24D) und die zweite Licht emittierende Vorrichtung (24C) herum zu leiten; und
einen Thermistor und/oder einen variablen Widerstand (60B, 70B), welche/welcher zwischen dem gleichen Endanschluss des Strangs wie die erste und die zweite konfigurierbare Abzweigung und der andere aus dem Kathoden- oder Anodenanschluss des Strangs gekoppelt sind/ist.

2. Feststoff-Leuchtvorrichtung nach Anspruch 1, wobei die erste (46C) und die zweite (46B) konfigurierbare Abzweigung jeweils wenigstens einen einstellbaren Widerstand, eine Sicherung, einen Schalter, einen Thermistor und einen variablen Widerstand umfassen.

3. Feststoff-Leuchtvorrichtung nach Anspruch 1, wobei jede aus den Licht emittierenden Feststoff-Vorrichtungen einen Anodenkontakt und einen Kathodenkontakt umfasst, wobei der Anodenkontakt von jeder von den Licht emittierenden Feststoff-Vorrichtungen mit dem Kathodenkontakt einer benachbarten Licht emittierenden Feststoff-Vorrichtung in dem Strang oder mit dem Anodenanschluss des Strangs gekoppelt ist, und der Kathodenkontakt von jeder von den Licht emittierenden Feststoff-Vorrichtungen mit dem Anodenkontakt einer benachbarten Licht emittierenden Feststoff-Vorrichtung in dem Strang oder mit dem Kathodenanschluss des Strangs gekoppelt ist.

4. Feststoff-Leuchtvorrichtung nach Anspruch 3, wobei die erste konfigurierbare Abzweigung (56C) einen elektrisch steuerbaren Schalter umfasst, wobei die Feststoff-Leuchtvorrichtung ferner eine Regel-/Steuerschaltung (50) umfasst, welche mit dem elektrisch steuerbaren Schalter gekoppelt ist und dazu eingerichtet ist, einen An/Aus-Zustand des elektrisch steuerbaren Schalters elektrisch zu regeln/steuern;
wobei die Feststoff-Leuchtvorrichtung ferner eine Schnittstelle (52) umfasst, welche mit der Regel-/Steuerschaltung gekoppelt ist und dazu eingerichtet ist, eine externe Eingabe aufzunehmen und in Reaktion darauf einen Schaltbefehl an die Regel-/Steuerschaltung bereitzustellen, wobei die Regel-/Steuerschaltung dazu eingerichtet ist, den An/Aus-Zustand des elektrisch steuerbaren Schalters in Reaktion auf den Schaltbefehl zu regeln/steuern.

5. Feststoff-Leuchtvorrichtung nach Anspruch 1, wobei die Licht emittierenden Feststoff-Vorrichtungen jeweilige Gruppen von seriell verbundenen Licht emittierenden Feststoff-Vorrichtungen umfassen, wobei die Gruppen von seriell verbundenen Licht emittierenden Feststoff-Vorrichtungen in Reihe zwischen dem Anodenkontakt des Strangs (34) und dem Kathodenkontakt des Strangs (34) verbunden sind, und wobei die erste und die zweite konfigurierbare Abzweigung zwischen jeweiligen Gruppen von seriell verbundenen Licht emittierenden Feststoff-Vorrichtungen und dem Katoden- (23B) oder Anoden- (23A) Anschluss des Strangs gekoppelt sind.

6. Feststoff-Leuchtvorrichtung nach Anspruch 5, wobei wenigstens zwei Gruppen von Licht emittierenden Feststoff-Vorrichtungen verschiedene Stückzahlen von Licht emittierenden Feststoff-Vorrichtungen umfassen, wobei eine erste Gruppe von Licht emittierenden Feststoff-Vorrichtungen direkt mit dem Kathodenanschluss (23B) des Strangs gekoppelt ist und eine erste Anzahl von Licht emittierenden Feststoff-Vorrichtungen umfasst, und wobei eine zweite Gruppe von Licht emittierenden Feststoff-Vorrichtungen nicht direkt mit dem Kathodenanschluss des Strangs gekoppelt ist und eine zweite Anzahl von Licht emittierenden Feststoff-Vorrichtungen umfasst, wobei die erste Anzahl ungleich der zweiten Anzahl ist.

7. Feststoff-Leuchtvorrichtung nach Anspruch 1, ferner umfassend wenigstens eines aus einem Thermistor und einem variablen Widerstand (70A), welcher mit dem Strang in Reihe gekoppelt ist.

8. Feststoff-Leuchtvorrichtung nach Anspruch 1, wobei der Strang einen ersten Strang (34A) von Licht emittierenden Dioden umfasst, welche dazu eingerichtet sind, Licht mit einer ersten Chromatizität zu emittieren, wobei die Vorrichtung ferner einen zweiten Strang (34B) von Licht emittierenden Vorrichtungen umfasst, welche dazu eingerichtet sind, Licht mit einer zweiten Chromatizität, welche von der ersten Chromatizität verschieden ist, zu emittieren.

9. Feststoff-Leuchtvorrichtung nach Anspruch 8, wobei die erste Chromatizität und die zweite Chromatizität nicht weiß sind, und wobei Licht, welches durch sowohl den ersten (34A) als auch den zweiten (34B) Strang emittiert wird, eine kombinierte Chromatizität aufweist, welche weiß ist.

10. Feststoff-Leuchtvorrichtung nach Anspruch 8, wobei der zweite Strang (34B) von Licht emittierenden Vorrichtungen eine zweite konfigurierbare Abzweigung umfasst, welche dazu eingerichtet ist, wenigstens etwas Strom in dem zweiten Strang um wenigstens eine Licht emittierende Vorrichtung in dem zweiten Strang herum zu leiten.

11. Feststoff-Leuchtvorrichtung nach Anspruch 1, wobei wenigstens zwei der Licht emittierenden Vorrichtungen (24A, 24B) parallel verbunden sind, und die konfigurierbare Abzweigung (66) dazu eingerichtet ist, Strom um die wenigstens zwei parallel verbundenen Licht emittierenden Vorrichtungen herum zu leiten.

12. Verfahren zum Betreiben einer Feststoff-Leuchtvorrichtung, umfassend eine Schaltung, umfassend eine Mehrzahl von Licht emittierenden Feststoff-Vorrichtungen, welche in Reihe verbunden sind, um einen ersten Strang von seriell verbundenen Licht emittierenden Feststoff-Vorrichtungen, welche dazu eingerichtet sind, Licht mit einer dominanten Wellenlänge in einem ersten Abschnitt des sichtbaren Spektrums zu emittieren, und einen zweiten Strang (34B) von Licht emittierenden Feststoff-Vorrichtungen zu bilden, welche dazu eingerichtet sind, Licht mit einer dominanten Wellenlänge in einem zweiten Abschnitt des sichtbaren Spektrums, welcher von dem ersten Abschnitt verschieden ist, zu emittieren, wobei der erste Strang einen Anodenanschluss (23A) an einem ersten Ende des ersten Strangs und einen Kathodenanschluss (23B) an einem zweiten Ende des ersten Strangs umfasst, wobei das Verfahren umfasst:
Leiten eines ersten Referenzstroms durch den ersten Strang (34A);
Leiten eines zweiten Referenzstroms durch den zweiten Strang (34B);
Messen von Farbe und/oder Intensität einer Lichtausgabe aus dem ersten Strang und dem zweiten Strang in Reaktion auf den ersten Referenzstrom und den zweiten Referenzstrom;
Bereitstellen von wenigstens zwei konfigurierbaren Abzweigungen (46B, 46C), wobei jede aus den wenigstens zwei Abzweigungen direkt zwischen einem Anschluss aus einer aus den Licht emittierenden Feststoff-Vorrichtungen und dem Anoden- (23A) oder dem Kathoden-(23B) Anschluss des ersten Strangs derart gekoppelt wird, dass die wenigstens zwei Abzweigungen mit einem gleichen Endanschluss des ersten Strangs gekoppelt werden; Bereitstellen eines Thermistors und/oder eines variablen Widerstands (60B, 70B), welche/welcher zwischen dem gleichen Endanschluss des Strangs wie die wenigstens zwei Abzweigungen und dem anderen aus dem Kathoden- oder Anodenanschluss des ersten Strangs gekoppelt werden/wird; und
Steigern des ersten Referenzstroms, um eine Reduktion an Lichtintensität zu kompensieren, wenn die Temperatur des ersten Strangs (34A) ansteigt.

## Revendications

1. Appareil d'éclairage à semi-conducteurs comprenant :
un circuit comprenant une pluralité de dispositifs électroluminescents, où les dispositifs électroluminescents sont reliés en série pour former une chaîne (34) comportant une borne d'anode (23A) au niveau d'une première extrémité de la chaîne et une borne de cathode (23B) au niveau d'une deuxième extrémité de la chaîne ;
un premier shunt configurable (46C) qui est relié entre une borne d'un premier dispositif électroluminescent (24D) dans la chaîne et l'une parmi la borne de cathode et la borne d'anode de la chaîne et qui est configuré pour dériver au moins une partie de courant autour du premier dispositif électroluminescent (24D) ;
un deuxième shunt configurable (46B) couplé entre une borne d'un deuxième dispositif électroluminescent (24C) et une même borne d'extrémité de la chaîne (34) que celle du premier shunt configurable (46C) et configuré pour dériver au moins une partie de courant autour du premier dispositif électroluminescent (24D) et du deuxième dispositif électroluminescent (24C) ; et
une thermistance et/ou une résistance variable (60B, 70B) couplée(s) entre la même borne d'extrémité de la chaîne que celle des premier et deuxième shunts configurables et l'autre de la borne de cathode ou de la borne d'anode de la chaîne.

2. Appareil d'éclairage à semi-conducteurs de la revendication 1, dans lequel les premier (46C) et deuxième (46B) shunts configurables comprennent chacun au moins l'un (e) parmi une résistance accordable, un fusible, un commutateur, une thermistance et une résistance variable.

3. Appareil d'éclairage à semi-conducteurs de la revendication 1, dans lequel chacun des dispositifs électroluminescents à semi-conducteurs comporte un contact d'anode et un contact de cathode, le contact d'anode de chacun des dispositifs électroluminescents à semi-conducteurs est couplé au contact de cathode d'un dispositif électroluminescent à semi-conducteurs adjacent dans la chaîne ou à la borne d'anode de la chaîne, et le contact de cathode de chacun des dispositifs électroluminescents à semi-conducteurs est couplé au contact d'anode d'un dispositif électroluminescent à semi-conducteurs adjacent dans la chaîne ou à la borne de cathode de la chaîne.

4. Appareil d'éclairage à semi-conducteurs de la revendication 3, dans lequel le premier shunt configurable (56C) comprend un commutateur à commande électrique, l'appareil d'éclairage à semi-conducteurs comprenant en outre un circuit de commande (50) couplé au commutateur à commande électrique et configuré pour commander électriquement un état de MARCHE/ARRÊT du commutateur à commande électrique ;
dans lequel l'appareil d'éclairage à semi-conducteurs comprend en outre une interface (52) couplée au circuit de commande et configurée pour recevoir une entrée externe et fournir, en réponse, une instruction de commutation au circuit de commande, où le circuit de commande est configuré pour commander l'état de MARCHE/ARRÊT du commutateur à commande électrique en réponse à l'instruction de commutation.

5. Appareil d'éclairage à semi-conducteurs de la revendication 1, dans lequel les dispositifs électroluminescents à semi-conducteurs comprennent des groupes respectifs de dispositifs électroluminescents à semi-conducteurs reliés en série, où les groupes de dispositifs électroluminescents à semi-conducteurs reliés en série sont reliés en série entre le contact d'anode de la chaîne (34) et le contact de cathode de la chaîne (34), et où les premier et deuxième shunts configurables sont couplés entre des groupes respectifs de dispositifs électroluminescents à semi-conducteurs reliés en série et la borne de cathode (23B) ou la borne d'anode (23A) de la chaîne.

6. Appareil d'éclairage à semi-conducteurs de la revendication 5, dans lequel au moins deux groupes de dispositifs électroluminescents à semi-conducteurs comprennent des nombres différents de dispositifs électroluminescents à semi-conducteurs, où un premier groupe de dispositifs électroluminescents à semi-conducteurs est couplé directement à la borne de cathode (23B) de la chaîne et comporte un premier nombre de dispositifs électroluminescents à semi-conducteurs, et où un deuxième groupe de dispositifs électroluminescents à semi-conducteurs n'est pas directement couplé à la borne de cathode de la chaîne et comporte un deuxième nombre de dispositifs électroluminescents à semi-conducteurs, où le premier nombre n'est pas égal au deuxième nombre.

7. Appareil d'éclairage à semi-conducteurs de la revendication 1, comprenant en outre au moins l'une parmi une thermistance et une résistance variable (70A) couplée en série à la chaîne.

8. Appareil d'éclairage à semi-conducteurs de la revendication 1, dans lequel la chaîne comprend une première chaîne (34A) de diodes électroluminescentes configurée pour émettre une lumière ayant une première chromaticité, l'appareil comprenant en outre une deuxième chaîne (34B) de dispositifs électroluminescents configurée pour émettre une lumière ayant une deuxième chromaticité, différente de la première chromaticité.

9. Appareil d'éclairage à semi-conducteurs de la revendication 8, dans lequel la première chromaticité et la deuxième chromaticité ne sont pas blanches, et dans lequel la lumière émise par les première (34A) et deuxième (34B) chaînes présente une chromaticité combinée qui est blanche.

10. Appareil d'éclairage à semi-conducteurs de la revendication 8, dans lequel la deuxième chaîne (34B) des dispositifs électroluminescents comprend un deuxième shunt configurable configuré pour dériver au moins une partie de courant dans la deuxième chaîne autour d'au moins un dispositif électroluminescent dans la deuxième chaîne.

11. Appareil d'éclairage à semi-conducteurs de la revendication 1, dans lequel au moins deux des dispositifs électroluminescents (24A, 24B) sont reliés en parallèle, et le shunt configurable (66) est configuré pour dériver le courant autour des au moins deux dispositifs électroluminescents reliés en parallèle.

12. Procédé de fonctionnement d'un appareil d'éclairage à semi-conducteurs comportant un circuit comprenant une pluralité de dispositifs électroluminescents à semi-conducteurs reliés en série pour former une première chaîne de dispositifs électroluminescents à semi-conducteurs reliés en série configurée pour émettre une lumière ayant une longueur d'onde dominante dans une première partie du spectre visible et une deuxième chaîne (34B) de dispositifs électroluminescents à semi-conducteurs configurée pour émettre une lumière ayant une longueur d'onde dominante dans une deuxième partie du spectre visible différente de la première partie, la première chaîne comportant une borne d'anode (23A) au niveau d'une première extrémité de la première chaîne et une borne de cathode (23B) au niveau d'une deuxième extrémité de la première chaîne, le procédé comprenant le fait :
de faire passer un premier courant de référence à travers la première chaîne (34A) ;
de faire passer un deuxième courant de référence à travers la deuxième chaîne (34B) ;
de mesurer la couleur et/ou l'intensité de la lumière délivrée en sortie à partir de la première chaîne et de la deuxième chaîne en réponse au premier courant de référence et au deuxième courant de référence ;
de fournir au moins deux shunts configurables (46B, 46C), où chacun des au moins deux shunts est directement couplé entre une borne de l'un des dispositifs électroluminescents à semi-conducteurs et la borne d'anode (23A) ou la borne de cathode (23B) de la première chaîne de sorte que les au moins deux shunts soient couplés à une même borne d'extrémité de la première chaîne ;
de fournir une thermistance et/ou une résistance variable (60B, 70B) couplée (s) entre la même borne d'extrémité de la chaîne que celle des au moins deux shunts et l'autre de la borne de cathode et de la borne d'anode de la première chaîne ; et
d'augmenter le premier courant de référence pour compenser une réduction de l'intensité lumineuse à mesure que la température de la première chaîne (34A) augmente.
